# EUROPÄISCHE PATENTANMELDUNG

(11) **EP 0 589 210 A1**
(43) Veröffentlichungstag der Anmeldung: **30.03.1994**
(21) Anmeldenummer: 93113319.3
(22) Anmeldetag: 20.08.1993
(51) Int. Cl.: H01L 27/07

(54) **Planares Halbleiterbauteil**

(30) Priorität: 23.09.1992 DE 4231829
(71) Anmelder: TEMIC TELEFUNKEN microelectronic GmbH, D-74072 Heilbronn (DE)
(72) Erfinder: Harmel, Hartmut, D-34369 Hofgeismar (DE); Ryman, Lennart, D-74078 Heilbronn (DE)
(74) Vertreter: Maute, Hans-Jürgen, Dipl.-Ing.

(57) **Zusammenfassung**

Das erfindungsgemäße planare Halbleiterbauteil (10) weist einen hochdotierten Channelstopperbereich (CS) von erstem Leitungstyp (n⁺) und mindestens folgende Bauelemente auf:
- eine Z-Diode (Z) mit den folgenden Bereichen von der Oberseite des Bauteils aus gesehen:
   -- einem oberen Diodenbereich (A) vom zweiten Leitungstyp (p);
   -- einem niedrig dotierten oberen Bauteilbereich (9) vom ersten Leitungstyp (n⁻), in welchem oberen Bauteilbereich der obere Diodenbereich und der Channelstopperbereich ausgebildet sind; und
   -- einem hochdotierten unteren Bauteilbereich (K + C) vom ersten Leitungstyp (n⁺); und
- ein Bauelement (T) mit
   -- einem ersten oberen Bauelementbereich (B), der mit dem oberen Diodenbereich im oberen Bauteilbereich ausgebildet ist und den Leitungstyp des oberen Diodenbereichs aufweist;
   -- dem genannten oberen Bauteilbereich (9);
   -- dem genannten unteren Bauteilbereich (K + C) und
   -- einem zweiten oberen Bauelementbereich (E), der in dem ersten oberen Bauelementbereich von dessen Oberfläche her in im wesentlichen einem Arbeitsgang mit dem Channelstopperbereich ausgebildet ist;
- wobei der Channelstopperbereich (CS) neben dem oberen Diodenbereich (A) ausgebildet ist und die Länge und/oder der spezifische Widerstand des Halbleiterbereichs zwischen dem oberen Diodenbereich und dem Channelstopperbereich einerseits sowie zwischen dem oberen Diodenbereich und dem unteren Bauteilbereich (K + C) andererseits so ausgebildet sind, daß der Ladungsträgerdurchbruch der Z-Diode zwischen dem oberen Diodenbereich und dem Channelstopperbereich erfolgt.

Bei diesem planaren Halbleiterbauteil besteht der Vorteil, daß ohne jeden zusätzlichen Verfahrensschritt dafür gesorgt werden kann, daß ein eventueller Durchbruch sicher an der Z-Diode und nicht etwa an einem anderen Bauelement erfolgt, und daß die Durchbruchspannung mit sehr engen Fertigungstoleranzen auf einen vorgegebenen Wert einstellbar ist.

## Beschreibung

Die Erfindung betrifft ein planares Halbleiterbauteil mit mindestens einer Z-Diode und mindestens einem weiteren Halbleiterbauelement. Von besonderem Interesse ist die Erfindung für ein Halbleiterbauteil mit zwei in Form einer Darlingtonschaltung miteinander verbundenen Leistungstransistoren und einer Z-Diode zwischen Kollektor und Basis eines der beiden Transistoren.

Bei einer p⁺-n⁻-n⁺-Diode hängt die Durchbruchspannung von der Dotierungskonzentration im n⁻-Bereich und vom Abstand zwischen dem p⁺- und dem n⁺-Bereich ab. Quantitative Zusammenhänge sind z. B. im Lehrbuch "Physics of Semiconductor Devices" von S. M. Sze, 2. Aufl., 1981, John Wiley & Sons erläutert und in einem Diagramm auf der dortigen Seite 105 dargestellt. Bei einem Abstand von 20 µm und einer Dotierungskonzentration bis etwa 7 x 10¹⁴ cm⁻³ beträgt die Durchbruchspannung etwa 400 V; mit zunehmender Dotierungskonzentration nimmt sie dann immer mehr ab. Bei konstanter Dotierungskonzentration von z. B. etwa 10¹⁴ cm⁻³, steigt die Durchbruchspannung mit zunehmender Größe des genannten Abstandes an und beträgt z. B. etwa 250 V bei 10 µm Abstand und etwa 1000 V bei etwa 50 µm Abstand.

Die Anmelderin vertreibt seit über zehn Jahren ein Halbleiterbauteil unter der Typenbezeichnung BUX 30 AV, das eine Darlingtonschaltung mit integrierter Z-Diode zwischen Kollektor und Basis eines der beiden Leistungstransistoren in der Darlingtonschaltung umfaßt. Die Durchbruchspannung der Z-Diode ist durch eine Struktur bestimmt, die den Punchtrough-Effekt nutzt. Dabei wird die Spannung durch die Dotierung einer p⁻-Schicht und die Tiefe einer an diese Schicht stoßenden n⁺-Schicht bestimmt. Dadurch, daß die Tiefe der n⁺-Schicht nicht sehr genau eingestellt werden kann, ist die Durchbruchspannung mit einer relativ großen Toleranz behaftet. Nachteilig ist weiterhin, daß die p⁻-Schicht gesondert erzeugt werden muß.

Ein planares Halbleiterbauteil mit ähnlicher Funktion wie das eben genannte, jedoch ohne Z-Diode ist in EP-B-0 179 099 beschrieben. In einem oberen Bauteilbereich sind ein Channelstopperbereich sowie die Basisbereiche zweier Leistungstransistoren der Darlingtonschaltung ausgebildet. Ein Ladungsträgerdurchbruch findet zwischen einem der Basisbereiche und dem gemeinsamen Kollektorbereich statt.

Für die meisten Anwendungen planarer Halbleiterbauteile mit vorgegebener Durchbruchspannung in der Höhe einiger 100 V ist es erwünscht, daß die Durchbruchspannung möglichst geringen Fertigungsschwankungen unterliegt. Der die Durchbruchspannung bestimmende Abstand zwischen dem Anodenbereich oder dem Basisbereich einerseits und dem Kathoden/Kollektor-Bereich andererseits läßt sich jedoch nur mit größeren Toleranzen einstellen, als es den für die Durchbruchspannung zulässigen Toleranzen entspricht. Daher ist immer ein Abgleich erforderlich. Beim Bauteil gemäß EP-B-0 179 099 erfolgt dieser Abgleich mit Hilfe einer speziellen Feldplatteneinrichtung.

Aus dem Vorstehenden ist ersichtlich, daß der Wunsch bestand, ein planares Halbleiterbauteil anzugeben, das so aufgebaut ist, daß sich die Durchbruchspannung auf einfache Weise mit geringeren Fertigungstoleranzen einstellen läßt.

Das erfindungsgemäße planare Halbleiterbauteil weist einen hoch dotierten Channelstopperbereich von erstem Leitungstyp und mindestens folgende Bauelemente auf:
- eine Z-Diode mit den folgenden Bereichen von der Oberseite des Bauteils aus gesehen:
   -- einem oberen Diodenbereich vom zweiten Leitungstyp;
   -- einem niedrig dotierten oberen Bauteilbereich vom ersten Leitungstyp, in welchem oberen Bauteilbereich der obere Diodenbereich und der Channelstopperbereich ausgebildet sind; und
   -- einem hoch dotierten unteren Bauteilbereich vom ersten Leitungstyp; und
- ein Bauelement mit
   -- einem ersten oberen Bauelementbereich, der mit dem oberen Diodenbereich im oberen Bauteilbereich ausgebildet ist und den Leitungstyp des oberen Diodenbereichs aufweist;
   -- dem genannten oberen Bauteilbereich;
   -- dem genannten unteren Bauteilbereich und
   -- einem zweiten oberen Bauelementbereich, der in dem ersten oberen Bauelementbereich von dessen Oberfläche her in im wesentlichen einem Arbeitsgang mit dem Channelstopperbereich ausgebildet ist;
- wobei der Channelstopperbereich neben dem oberen Diodenbereich ausgebildet ist und die Länge und/oder der spezifische Widerstand des Halbleiterbereichs zwischen dem oberen Diodenbereich und dem Channelstopperbereich einerseits sowie zwischen dem oberen Diodenbereich und dem unteren Bauteilbereich andererseits so ausgebildet sind, daß der Ladungsträgerdurchbruch der Z-Diode zwischen dem oberen Diodenbereich und dem Channelstopperbereich erfolgt.

Zum Veranschaulichen der Vorteile dieses Bauteils sei zunächst angenommen, daß das außer der Z-Diode vorhandene Bauelement ein Leistungstransistor in einer Darlingtonschaltung sei, daß es sich also um ein Halbleiterbauteil mit der Funktion des bekannten Bauteils BUX 30 AV handele. Es wird aber die Durchbruchspannung nicht mehr durch die Dotierung einer p⁻-Schicht und die Tiefe einer n⁺-Schicht eingestellt, sondern durch den Abstand zwischen dem Anodenbereich und dem Channelstopperbereich und/oder durch eine oberflächennahe Dotierung im Gebiet zwischen diesen Bereichen. Der letztere Abstand oder die oberflächennahe Dotierung läßt sich erheblich genauer einstellen als die Tiefe einer n⁺-Schicht. Zusätzlich wird dann, wenn die Durchbruchsspannung ausschließlich über den Abstand zwischen Anode und Channelstopper eingestellt wird, der Vorteil erzielt, daß nur Herstellschritte verwendet werden, die beim Herstellen des Transistors ohnehin ausgeführt werden. Die Z-Diode läßt sich also mit sehr genau einstellbarer Durchbruchspannung ohne besonderen Fertigungsaufwand herstellen, Wird die Durchbruchspannung alleine oder zusätzlich mit einer oberflächennahen Dotierung zwischen Anode und Channelstopper eingestellt, ist zwar ein zusätzlicher Verfahrensschritt nötig, jedoch nur ein solcher, der keine besonderen Strukturierungstoleranzen erfordert.

Wenn statt mindestens eines Transistors ein anderes Bauelement herzustellen ist, das mindestens einen Bereich aufweist, der entsprechend dem Anodenbereich einer Z-Diode hergestellt wird, und mindestens einen Bereich aufweist, der sich zusammen mit einem Channelstopperbereich herstellen läßt, werden die vorstehend genannten Vorteile in völlig entsprechender Weise erzielt. Ein solches Bauelement ist z. B. ein Thyristor, der statt einer n-p-n-Bereichsfolge, wie der genannte Transistor, eine p-n-p-n-Bereichsfolge aufweist.

Es sei darauf hingewiesen, daß die Z-Diode und das weitere Bauelement nicht notwendigerweise monolithisch zusammengefaßt sein müssen. Die Z-Diode kann auch getrennt von dem mindestens einen weiteren Bauelement von außen anschließbar sein.

Zum Erzielen einer möglichst wenig von Fertigungsschwankungen abhängigen Durchbruchspannung ist es weiterhin von Vorteil, die Halbleiteroberfläche im Abschnitt zwischen dem oberen Diodenbereich und dem Channelstopperbereich unmittelbar durch eine SIPOS-Passivierung abzudecken. Hierbei treten geringere Streuungen auf, als wenn eine SiO₂-Abdeckung verwendet wird, und es kommt zu keinen Instabilitäten (kein Junction-walk-out).

Wie eingangs genannt, hängt die Durchbruchspannung nicht nur vom Abstand zwischen den zwei Bereichen ab, zwischen denen schließlich der Durchbruch stattfindet, sondern auch von der Dotierungskonzentration, d. h. dem spezifischen Widerstand im genannten Bereich. Die Bedingung, daß ein Durchbruch zwischen dem Anodenbereich und dem Channelstopperbereich und nicht zwischen dem Anodenbereich und dem Kathodenbereich stattfinden soll, läßt sich demgemäß nicht nur dadurch erzielen, daß der Abstand zwischen den ersten beiden genannten Bereichen kleiner gewählt wird als der Abstand zwischen den beiden anschließend genannten Bereichen, sondern auch dadurch, daß der spezifische Widerstand des Halbleiterbereichs zwischen den beiden erstgenannten Bereichen kleiner gewählt wird als derjenige des Halbleiterbereichs zwischen den zwei anschließend genannten Bereichen. Auch diese Maßnahme läßt sich mit sehr geringer Fertigungstoleranz realisieren, da es sich um die Dotierungskonzentration in einem dünnen Halbleiterbereich handelt, der unmittelbar unter der Oberfläche des Bauteils liegt.

Die Erfindung wird im folgenden anhand von durch Figuren veranschaulichten Ausführungsbeispielen näher erläutert.
Fig. 1a und b: schematischer Teilquerschnitt durch ein planares Halbleiterbauteil mit einer Z-Diode und einem Transistor bzw. zugehöriges Schaltbild zu diesem planaren Halbleiterbauteil;
Fig. 2a bis h: schematische Teilquerschnitte zum Veranschaulichen eines Verfahrens zum Herstellen des planaren Halbleiterbauteils gemäß Fig. 1a;
Fig. 3: Darstellung entsprechend der von Fig. 2a, jedoch zum Veranschaulichen eines Epitaxieverfahrens;
Fig. 4: Darstellung, die sich auf die Fig. 2a und 2c bezieht, zum Erläutern, wie der Abstand zwischen einem Anodenbereich und einem Channelstopperbereich mit Hilfe einer vorgegebenen Maskenüberlappung eingestellt wird;
Fig. 5: schematischer Teilquerschnitt durch ein planares Halbleiterbauteil mit einem Halbleiterbereich verringerten spezifischen Widerstandes zwischen einem Channelstopperbereich und einem Anodenbereich; und
Fig. 6: schematische Darstellung entsprechend der von Fig. 2a, jedoch zum Beschreiben eines Verfahrens zum Herstellen des Halbleiterbauteils gemäß Fig. 5.
Fig. 7a bis d: Diagramme zum Erläutern der Funktion erfindungsgemäßer Halbleiterbauteile.

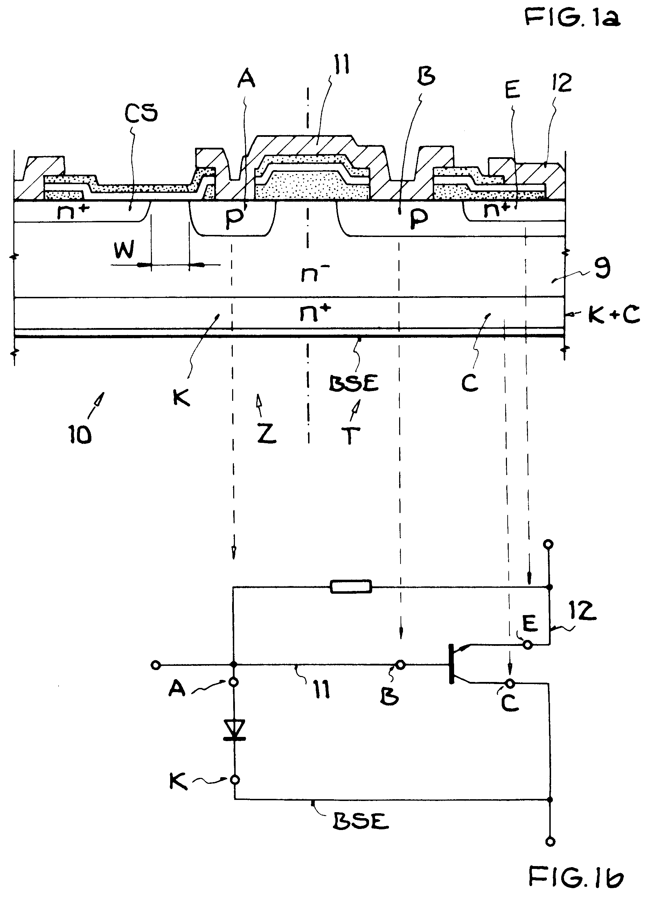

Das in Fig. 1a in einem schematischen Teilquerschnitt dargestellte planare Halbleiterbauteil 10 verfügt über eine Z-Diode Z im linken Teil und einen Transistor T im rechten Teil. Die Verschaltung zwischen der Diode und dem Transistor geht aus Fig. 1b hervor. In Fig. 1b ist die Anode der Z-

Diode mit A und deren Kathode mit K bezeichnet. Die Basis des Transistors trägt den Buchstaben B, der Kollektor den Buchstaben C und der Emitter den Buchstaben E. Die entsprechenden Buchstaben sind in das Schnittbild von Fig. 1a eingetragen. Der in Fig. 1b eingezeichnete Widerstand ist im Schnittbild von Fig. 1a nicht erkennbar; außer diesem Widerstand können noch weitere Widerstände vorhanden sein.

Das Halbleiterbauteil 10 verfügt über einen oberen Bauteilbereich 9 aus n⁻-Si und einen unteren Bauteilbereich K+C aus n⁺-Si, der als Kathode K der Z-Diode Z und als Kollektor C des Transistors T wirkt. Der untere Bauteilbereich K+C wird von einer Rückseitenelektrode BSE abgedeckt, die z.B. aus der Schichtfolge Cr-Ni-Au besteht.

Im oberen Bauteilbereich 9 sind von links nach rechts nebeneinanderliegend ein n⁺-Channelstopperbereich CS, ein p-Anodenbereich A und ein p-Basisbereich B ausgebildet. In den Basisbereich ist von der Oberseite des Bauteils her ein n⁺-Emitterbereich E eindiffundiert. Bereiche der Oberfläche sind durch eine SiO₂-Isolierschicht und eine SIPOS-Passivierung abgedeckt, wobei letztere aus einer unteren O(Oxygen doped)-SIPOS(SemiInsulating POlycrystalline Silicon)-Schicht und einer oberen N(Nitrogen doped)-SIPOS-Schicht besteht. Im Abschnitt zwischen dem Channelstopperbereich CS und dem Anodenbereich A liegt die SIPOS-Passivierung unmittelbar auf der Oberfläche des oberen Bauteilbereichs. Die Leitfähigkeit der O-SIPOS-Schicht sorgt für einen schnellen Ladungsausgleich an der Bauteiloberfläche beim Durchbruch, was für eine stabile Durchbruchspannung sorgt. Die freiliegenden Teile der Oberfläche sind durch Elektroden kontaktiert, und zwar durch eine Anoden/Basis-Elektrode 11 bzw. eine Emitterelektrode 12.

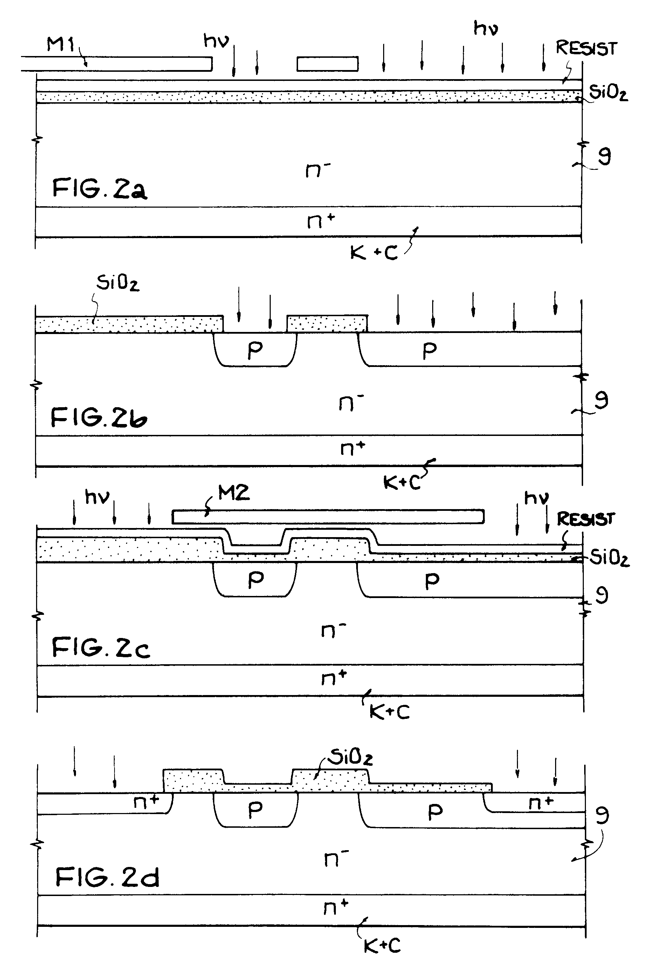

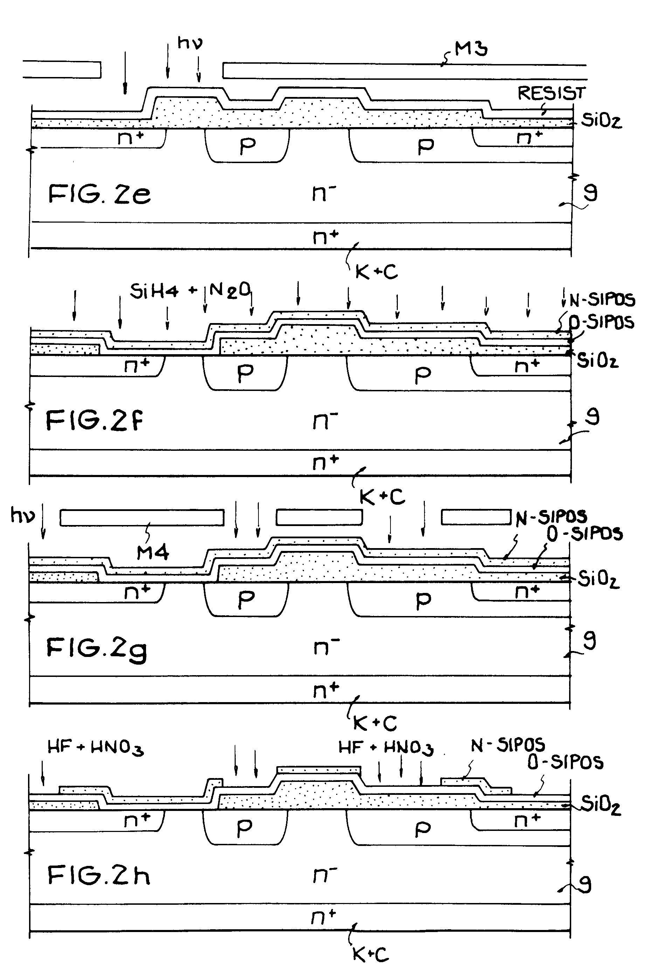

Anhand von Fig. 2 wird nun ein Verfahren zum Herstellen des Bauteils gemäß Fig. 1a beschrieben.

Ausgegangen wird von einem handelsüblichen n⁻-Substrat aus Si mit n⁺-Rückseitendotierung. Der n⁻-Bereich ist der obere Bauteilbereich 9, während die n⁺-dotierte Schicht den unteren Bauteilbereich K+C darstellt. Dieses Ausgangsmaterial wird thermisch oxidiert, so daß eine SiO₂-Schicht entsteht, auf die dann ein Positiv-Photoresist aufgebracht wird. Dieser wird durch eine Maske M1 hindurch an denjenigen Stellen belichtet (Fig. 2a), an denen die Anode und die Basis durch p-Dotierung hergestellt werden sollen. Nach dem Entwickeln des Resists und dem Ätzen der SiO₂-Schicht an den entwickelten Stellen erfolgt die p-Dotierung durch Ionenimplantation von Bor (Fig. 2b) bis zueiner Konzentration von etwa 5·10¹⁷ bis etwa 2·10¹⁸ cm⁻³. Anschließend wird bei der erforderlichen Nachdiffusion erneut SiO₂ thermisch aufgewachsen. Auf die SiO₂-Schicht wird ein Positiv-Photoresist aufgebracht. Durch eine Maske M2 hindurch werden nun diejenigen Stellen belichtet (Fig. 2c), an denen der Channelstopperbereich und der Emitterbereich entstehen sollen. Nach dem Entwickeln des Resists und dem Abätzen der SiO₂-Schicht an den entwickelten Stellen erfolgt die n⁺-Dotierung dadurch, daß Phosphor auf den freigelegten Stellen der Halbleiteroberfläche abgeschieden und dann thermisch eindiffundiert wird. Das Abscheiden des Phosphors erfolgt z. B. dadurch, daß POCl₃ mit Hilfe eines Trägergases, z. B. N₂, über das auf etwa 1100 °C befindliche Bauteil transportiert wird (Fig. 2d). Beim thermischen Eindiffundieren des Phosphors wächst wieder eine SiO₂-Schicht über dem gesamten Bauteil auf.

Die eben genannte SiO₂-Schicht wird erneut mit einem Positiv-Photoresist abgedeckt, der nun durch eine Maske M3 hindurch dort belichtet wird (Fig. 2e), wo die SiO₂-Schicht entfernt werden soll, damit eine SIPOS-Passivierung direkt auf die Halbleiteroberfläche aufgetragen werden kann. Dies ist vor allem im Abschnitt zwischen dem Channelstopperbereich CS und dem Anodenbereich A erforderlich. Wenn der Channelstopperbereich aus irgendeinem Grund zu kontaktieren ist, läßt man im betreffenden Bereich die SiO₂-Schicht aus einem Grund stehen, wie er in Zusammenhang mit Fig. 2f erläutert wird. Nach dem Entwickeln des in Schritt 2e belichteten Resists wird die SIPOS-Passivierung aufgebracht (Schritt 2f). Hierzu wird SiH₄ mit Hilfe eines Trägergases, z. B. N₂, über das auf 600 - 640 °C befindliche Bauteil geleitet. Dem Gasgemisch wird N₂O in solcher Menge zugesetzt, daß eine Sauerstoffdotierung von etwa 10 bis 20 Atom% erzielt wird. Hierbei entsteht halbisolierendes polykristallines oder amorphes Silizium. Wenn auf diese Weise eine O-SIPOS-Schicht mit einer Dicke von 0,5 µm aufgebracht ist, wird dem Gasgemisch NH₃ statt N₂O zugesetzt, um nun die nitridähnliche N-SIPOS-Schicht zu erzielen. Die SIPOS-Passivierung ist dann vollständig, wenn die N-SIPOS-Schicht eine Dicke von etwa 0,1 µm aufweist.

Nun sind noch Kontaktöffnungen und dann die Elektroden 11 und 12 zu erzeugen. Hierzu wird die SIPOS-Passivierung mit einem Positiv-Photoresist abgedeckt, der dann durch eine Maske M4 hindurch belichtet wird (Fig. 2g). Nach dem Entwikkeln des Resists wird zunächst die N-SIPOS-Schicht mit Hilfe heißer Phosphorsäure abgeätzt. Diese Ätze stoppt auf der O-SIPOS-Schicht. Es wird dann der Photoresist entfernt, und es wird die N-SIPOS-Schicht als Ätzmaske für die O-SIPOS-Schicht verwendet. Deren Ätzen erfolgt mit einer Ätze, wie sie auch für Silizium typischerweise verwendet wird, also z. B. einer Mischung aus HF und HNO₃ (Fig. 2h). Hätte man die SIPOS-Passivierung unmittelbar auf die gesamte Halbleiteroberfläche aufgebracht, würde beim strukturierten Abätzen der O-SIPOS-Schicht auch die Halbleiterschicht angegriffen werden. Die SiO₂-Schicht wirkt jedoch als Ätzstopp. Das strukturierte Abätzen der SiO₂-Schicht erfolgt mit Hilfe gepufferter Flußsäure, die das Halbleitermaterial nicht angreift. Die Kontaktöffnungen können aber auch z.B. durch ein Plasmaätzverfahren erzeugt werden. Nachdem auf diese Weise die zu kontaktierenden Halbleiterstellen freigelegt sind, werden die Elektroden 10 und 11 in bekannter Weise durch Aufdampfen von Aluminium mit anschließendem photolithographischen Strukturieren hergestellt. So wird das Bauteil gemäß dem schematischen Schnittbild von Fig. 1a erhalten.

Gemäß Fig. 2a wurde von einem handelsüblichen n⁻-Substrat (ca. 1·10¹⁴ cm⁻³) mit n⁺-dotierter Rückseitenschicht (ca. 5·10¹⁹ cm⁻³) ausgegangen. Stattdessen kann auch von einem handelsüblichen n⁺-Epitaxiesubstrat (ca. 2 - 3·10¹⁸ cm⁻³) als unterem Bauteilbereich K+C ausgegangen werden, auf den eine erste Epitaxieschicht EP1 aus n-Si und eine zweite Epitaxieschicht EP2 aus n⁻-Si aufgebracht werden. Die zweite Epitaxieschicht EP2 stellt dabei den oberen Bauteilbereich 9 dar, in den die vorstehend erläuterten Halbleiterstrukturen eindiffundiert werden. Diese abgeänderte Schichtfolge hat keinerlei Einfluß auf das beschriebene Herstellverfahren.

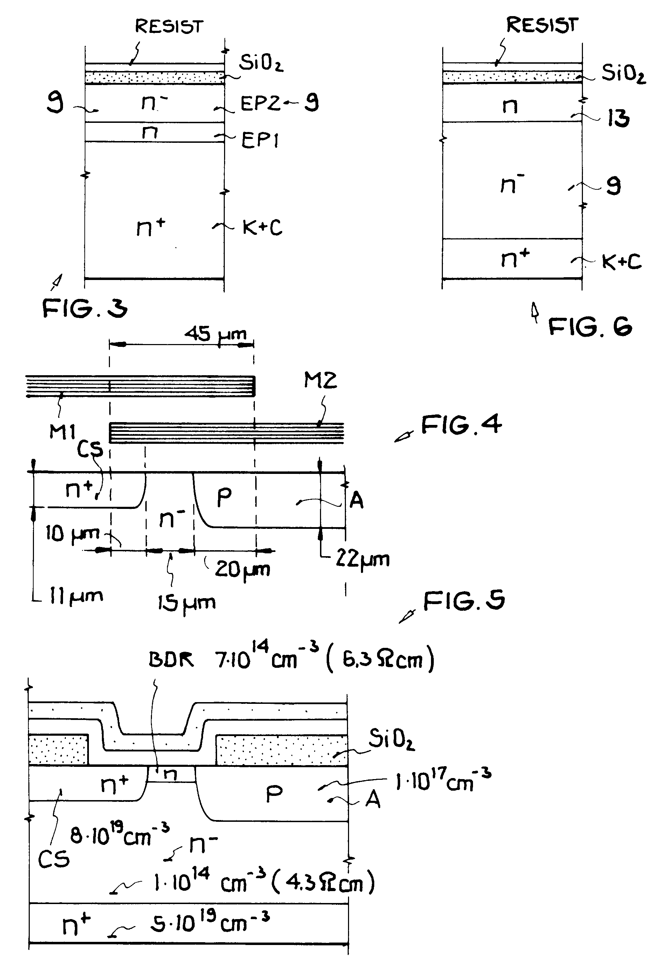

Beim Bauteil gemäß Fig. 1a wird die Durchbruchspannung der Z-Diode Z vom Abstand w zwischen dem Channelstopperbereich CS und dem Anodenbereich A bestimmt. Durch welche Schritte dieser Abstand im Herstellablauf festgelegt wird, wird anhand von Fig. 4 näher veranschaulicht.

Fig. 4 zeigt ganz oben den linken Teil der Maske M1, wie sie auch in Fig. 2a dargestellt ist. Wenn der Positiv-Photoresist durch diese Maske M1 hindurch belichtet wird, wirkt sich der Belichtungsvorgang in Fig. 4 auch noch etwas nach links hin, also unter die Maske, aus. Auch das anschließende Diffundieren gemäß Fig. 2b wirkt sich an der in Fig. 4 betrachteten Stelle nach links hin, also unter die SiO₂-Schutzschicht (in Fig. 2b), aus. Insgesamt führt dies dazu, daß bei einem 22 µm tiefen Anodenbereich A der linke Rand dieses Bereichs um etwa 20 µm weiter nach links liegt, als es der rechten Kante der Maske M1 entspricht. Entsprechendes, nur jeweils umgekehrt, gilt beim Erzeugen des Channelstopperbereichs CS mit Hilfe der Maske M2, die in Fig. 4 unter der Maske M1 dargestellt ist. Bei einem 11 µm tiefen Channelstopperbereich CS verschiebt sich dessen rechte Kante um etwa 10 µm nach rechts gegenüber dem linken Ende der Maske M2.

Beim Ausführungsbeispiel überlappten sich die Masken M1 und M2 um 45 µm, was aufgrund der vorstehend genannten Randverschiebungen zu einem Abstand w von 45 µm - 20 µm - 10 µm = 15 µm führte. Bei einer n⁻-Dotierung von 1 x 10¹⁴ cm⁻³ (spez. Widerstand etwa 43 Ωcm) wurde bei diesem Abstand eine Durchbruchspannung von 400 V mit einer Fertigungstoleranz von ± 5 % erzielt. Durch Variieren der Maskenüberlappung -oder der Dotierungstiefe und damit der Randverschiebung -läßt sich die jeweils gewünschte Durchbruchspannung einstellen.

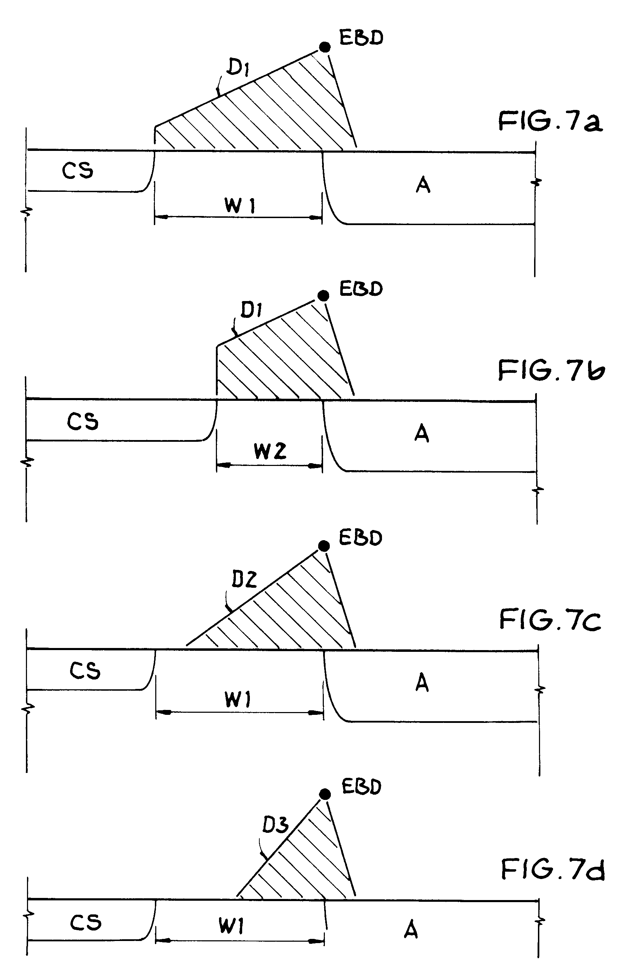

Fig. 5 veranschaulicht einen Aufbau, bei dem die Durchbruchspannung nicht nur über den Abstand w zwischen dem Channelstopperbereich CS und dem Anodenbereich A eingestellt wird, sondern auch durch Variieren des spezifischen Widerstandes in einem Durchbruchsbereich BDR zwischen den eben genannten Bereichen, welcher Durchbruchsbereich direkt unterhalb oder ganz nahe bei der Halbleiteroberfläche durch leichtes weiteres Dotieren des n⁻-dotierten oberen Bauteilbereichs 9 hergestellt ist. Die n-Dotierung im Durchbruchsbereich BDR beträgt beim Ausführungsbeispiel 7 x 10¹⁴ cm⁻³ (6,3 Ωcm) gegenüber 1 x 10¹⁴ cm⁻³ (43 Ωcm) im oberen Bauteilbereich. Dies verringert die Durchbruchspannung auf etwa 330 V.

Fig. 6 veranschaulicht, von welcher zu Fig. 2a entsprechenden Struktur ausgegangen werden muß, um das Bauteil gemäß Fig. 5 zu erhalten. Die Struktur von Fig. 6 weist abweichend von der von Fig. 2a noch zusätzlich eine dünne n-dotierte Schicht 13 auf, die dann zum Durchbruchsbereich BDR führt. Am fertigen Bauteil ist diese Schicht auch im Bereich zwischen dem Anodenbereich und dem Basisbereich direkt unterhalb der Halbleiteroberfläche vorhanden.

Die Figuren 7a bis 7d veranschaulichen den Verlauf des elektrischen Feldes zwischen Anode A und Channelstopper CS für vier verschiedende Fälle jeweils kurz vor Erreichen der Durchbruchsfeldstärke EBD, die für alle Fälle im wesentlichen die selbe ist. Die Spannung zwischen den beiden Bereichen ist durch das Wegintegral der Feldstärke gegeben, das in den Figuren als schraffierte Fläche dargestellt ist.

In den Fällen a) und b) liegt jeweils dieselbe Dotierung D1, nämlich diejenige des oberen Bauteilbereichs 9, im Gebiet zwischen den beiden Bereichen vor. Jedoch liegt im Fall a) ein Abstand w1 und im Fall b) ein kleinerer Abstand w2 vor. Es ist unmittelbar erkennbar, daß im Fall b) das genannte Wegintegral und damit die Durchbruchspannung kleiner ist als im Fall a). Die Durchbruchspannung ließe sich auch noch durch die Dotierung und damit die Steigung der Feldstärkelinie einstellen.

In den Fällen c) und d) liegt beidemale der Abstand w1 vor, jedoch ist nun die Dotierung so hoch, daß der Channelstopper außerhalb der Raumladungszone um die Anode liegt. Damit hängt die Durchbruchspannung nicht mehr vom Abstand zwischen diesen beiden Bereichen ab. Es ist nun aber im Fall d) die Dotierung D3 höher als die Dotierung D2 im Fall c). Wie leicht erkennbar, ist bei höherer Dotierung das genannte Wegintegral und damit die Durchbruchspannung kleiner.

Aus Fig. 7 ist somit erkennbar, daß die Durchbruchspannung über den Abstand w oder über die Dotierung D oder über beides eingestellt werden.

Es sei darauf hingewiesen, daß das Halbleiter-Ausgangsmaterial weitere Bereiche außer dem oberen Bauteilbereich 9 und dem unteren Bauteilbereich K+C aufweisen kann, z. B. den Epitaxiebereich EP1 gemäß Fig. 3. In den oberen Bauteilbereich 9 können noch weitere Bereiche eindiffundiert sein als die oben beschriebenen, z. B. ein weiterer p-Bereich im oberen n⁺-Bereich im Fall eines Thyristors. Statt eines N-SIPOS-Schicht kann eine solche aus Si₃N₄vorhanden sein. Neben der Z-Diode können zahlreiche weitere Bauelemente im planaren Halbleiterbauteil ausgebildet sein. Wesentlich ist allein, daß eines dieser Bauelemente eine hoch dotierte Schicht aufweist, die denjenigen Leitungstyp aufweist, der dem Leitungstyp entgegengesetzt ist, wie er für den oberen Diodenbereich verwendet wird. In diesem Fall ist zum Einstellen der Durchbruchspannung der Z-Diode kein einziger zusätzlicher Verfahrensschritt erforderlich, sondern es ist lediglich darauf zu achten, daß beim Herstellen des genannten hoch dotierten Bereichs zugleich ein Channelstopperbereich neben dem oberen Diodenbereich hergestellt wird, wobei ein solcher Abstand und/oder eine solche Dotierung zwischen diesen beiden eingehalten wird, daß dadurch die Durchbruchspannung bestimmt ist. Sollte eine besondere Dotierung zwischen den beiden Bereichen eingestellt werden, z.B in Form der dünnen n-Schicht 13, ist zwar ein zusätzlicher Verfahrensschritt erforderlich, jedoch handelt es sich hierbei um einen äußerst einfachen Dotierungsschritt ohne jegliches Strukturierungserfordernis.

## Patentansprüche

1. Planares Halbleiterbauteil (10) mit einem hochdotierten Channelstopperbereich (CS) von erstem Leitungstyp (n⁺) und mit mindestens den folgenden Bauelementen:
- einer Z-Diode (Z) mit den folgenden Bereichen von der Oberseite des Bauteils aus gesehen:
-- einem oberen Diodenbereich (A) vom zweiten Leitungstyp (p);
-- einem niedrig dotierten oberen Bauteilbereich (9) vom ersten Leitungstyp (n⁻), in welchem oberen Bauteilbereich der obere Diodenbereich und der Channelstopperbereich ausgebildet sind; und
-- einem hochdotierten unteren Bauteilbereich (K + C) vom ersten Leitungstyp (n⁺); und
- einem Bauelement (T) mit
-- einem ersten oberen Bauelementbereich (B), der mit dem oberen Diodenbereich im oberen Bauteilbereich ausgebildet ist und den Leitungstyp des oberen Diodenbereichs aufweist;
-- dem genannten oberen Bauteilbereich (9);
-- dem genannten unteren Bauteilbereich (K + B) und
-- einem zweiten oberen Bauelementbereich (E), der in dem ersten oberen Bauelementbereich von dessen Oberfläche her in im wesentlichen einem Arbeitsgang mit dem Channelstopperbereich ausgebildet ist;
- wobei der Channelstopperbereich (CS) neben dem oberen Diodenbereich (A) ausgebildet ist und die Länge und/oder der spezifische Widerstand des Halbleiterbereichs zwischen dem oberen Diodenbereich und dem Channelstopperbereich einerseits sowie zwischen dem oberen Diodenbereich und dem unteren Bauteilbereich (K + C) andererseits so ausgebildet sind, daß der Ladungsträgerdurchbruch der Z-Diode zwischen dem oberen Diodenbereich und dem Channelstopperbereich erfolgt.

2. Halbleiterbauteil nach Anspruch 1, **dadurch gekennzeichnet,** daß die Halbleiteroberfläche im Abschnitt zwischen dem oberen Diodenbereich (A) und dem Channelstopperbereich (CS) unmittelbar durch eine O-SIPOS-Schicht abgedeckt ist.

3. Halbleiterbauteil nach Anspruch 2, **dadurch gekennzeichnet,** daß die O-SIPOS-Schicht durch eine N-SIPOS-Schicht abgedeckt ist.

4. Halbleiterbauteil nach einem der Ansprüche 1 bis 3, **dadurch gekennzeichnet,** daß zwischen dem oberen Diodenbereich (A) und dem Channelstopperbereich (CS) im oberen Bauteilbereich (9) ein Durchbruchbereich (BDR) ausgebildet ist, dessen spezifischer Widerstand geringer ist als der des oberen Bauteilbereichs.

5. Halbleiterbauteil nach einem der Ansprüche 1 bis 4, **dadurch gekennzeichnet,** daß der obere Diodenbereich die Anode (A) der Z-Diode (Z) bildet, der untere Bauteilbereich die Kathode (K) der Z-Diode und den Kollektor (C) eines Transistors (T) bildet, und der erste obere Bauelementbereich die Basis (B) und der zweite obere Bauelementbereich den Emitter (E) des Transistor bildet.

6. Halbleiterbauteil nach einem der Ansprüche 1 bis 5, **dadurch gekennzeichnet,** daß der obere Diodenbereich (A) und der erste obere Bauelementbereich (B) einen einzigen Halbleiterbereich (A+B) bilden.

7. Halbleiterbauteil nach einem der Ansprüche 1 bis 6, **dadurch gekennzeichnet,** daß der obere Bauteilbereich (9) n⁻-dotiert ist, der obere Diodenbereich (A) und der erste obere Bauelementbereich (B) p-dotiert sind und der zweite obere Bauelementbereich (E), der Channelstopperbereich (CS) und der untere Bauteilbereich (K + C) n⁺-dotiert sind.
